# EUROPEAN PATENT APPLICATION

(11) **EP 4 450 239 A1**
(43) Date of publication of application: **23.10.2024**
(21) Application number: 24166681.7
(22) Date of filing: 27.03.2024
(51) Int. Cl.: B25J 9/16

(54) **CONNECTOR INSERTION METHOD AND INSPECTION METHOD**

(30) Priority: 18.04.2023 JP 2023067868
(71) Applicant: Seiko Epson Corporation, Tokyo 160-8801 (JP)
(72) Inventor: MIYAMOTO, Masataka, Suwa-shi, Nagano, 392-8502 (JP)
(74) Representative: MERH-IP Matias Erny Reichl Hoffmann Patentanwälte PartG mbB

(57) **Abstract**

A connector insertion method for inserting a first connector into a second connector by using a robot includes a gripping step of gripping the first connector by the robot, a first insertion step of inserting the distal end section of the first connector into the second connector in a state where the central axis of the first connector is shifted with respect to the central axis of the second connector, an axis alignment step of aligning the central axis of the first connector with the central axis of the second connector by displacing the first connector, and a second insertion step of advancing the first connector in a direction along the central axis of the first connector and inserting the first connector into the second connector.

## Description

The present application is based on, and claims priority from JP Application Serial Number 2023-067868, filed April 18, 2023, the disclosure of which is hereby incorporated by reference herein in its entirety.

### BACKGROUND

### 1. Technical Field

The present disclosure relates to a connector insertion method and an inspection method.

### 2. Related Art

JP-A-2021-012784 discloses a robot apparatus for performing a step of gripping a first connector using a robot and inserting the first connector into a second connector, a step of resonating the first connector and the second connector in a state where the first connector is inserted into the second connector, and a step of adjusting the insertion depth of the first connector based on resonance frequencies.

In this way, the insertion depth is adjusted in the robot apparatus of JP-A-2021-012784 after the first connector is inserted into the second connector. However, the operation of inserting the first connector into the second connector is not planned out at all. Therefore, there is a concern that the first connector cannot be smoothly inserted into the second connector and that the insertion will take time or the first or second connector will be damaged.

### SUMMARY

A connector insertion method of the present disclosure is a connector insertion method for inserting a first connector into a second connector by using a robot, the connector insertion method including:
a gripping step of gripping the first connector by the robot;
a first insertion step of inserting a distal end section of the first connector into the second connector in a state where a central axis of the first connector is shifted from a central axis of the second connector;
an axis alignment step of displacing the first connector to align the central axis of the first connector with the central axis of the second connector; and
a second insertion step of advancing the first connector in a direction along the central axis of the first connector to insert the first connector into the second connector. An inspection method of the present disclosure is an inspection method of performing an inspection by inserting a first connector into a second connector using a robot, the inspection method including:
   a gripping step of gripping the first connector by the robot;
   a first insertion step of inserting a distal end section of the first connector into the second connector in a state where a central axis of the first connector is shifted from a central axis of the second connector;
   an axis alignment step of aligning a central axis of the first connector with a central axis of the second connector;
   a second insertion step of advancing the first connector in a direction along the central axis of the first connector to insert the first connector into the second connector; and
   a pull-out step of pulling out the first connector from the second connector by retracting the first connector in a direction along the central axis of the first connector.

### BRIEF DESCRIPTION OF THE DRAWINGS

FIG. 1 is a configuration diagram of a robot system according to a first embodiment.
FIG. 2 is a plan view showing a cable used in inspection.
FIG. 3 is a rear view of an electronic device, which is the target of inspection.
FIG. 4 is a flow chart of an inspection method performed using the robot system.
FIG. 5 is a diagram for explaining the inspection method.
FIG. 6 is a diagram for explaining the inspection method.
FIG. 7 is a diagram for explaining the inspection method.
FIG. 8 is a diagram for explaining the inspection method.
FIG. 9 is a diagram for explaining the inspection method.
FIG. 10 is a diagram for explaining the inspection method.
FIG. 11 is a diagram for explaining the inspection method.
FIG. 12 is a diagram for explaining the inspection method.
FIG. 13 is a diagram for explaining the inspection method.
FIG. 14 is a diagram for explaining the inspection method.
FIG. 15 is a perspective view showing a first connector and a second connector used in an inspection method of a second embodiment.
FIG. 16 is a diagram for explaining the inspection method.
FIG. 17 is a diagram for explaining the inspection method.
FIG. 18 is a diagram for explaining the inspection method.
FIG. 19 is a diagram for explaining the inspection method.
FIG. 20 is a diagram for explaining the inspection method.
FIG. 21 is a configuration diagram of a robot system according to a fourth embodiment.
FIG. 22 is a perspective view showing a gripping jig used in an inspection performed by a robot system according to a fifth embodiment.
FIG. 23 is an exploded perspective view of the gripping jig shown in FIG. 22.
FIG. 24 is a perspective view showing a state in which the gripping jig is held by a tool.

### DESCRIPTION OF EMBODIMENTS

Hereinafter, a connector insertion method and an inspection method of the present disclosure will be described in detail with reference to embodiments shown in the accompanying drawings.

### FIRST EMBODIMENT

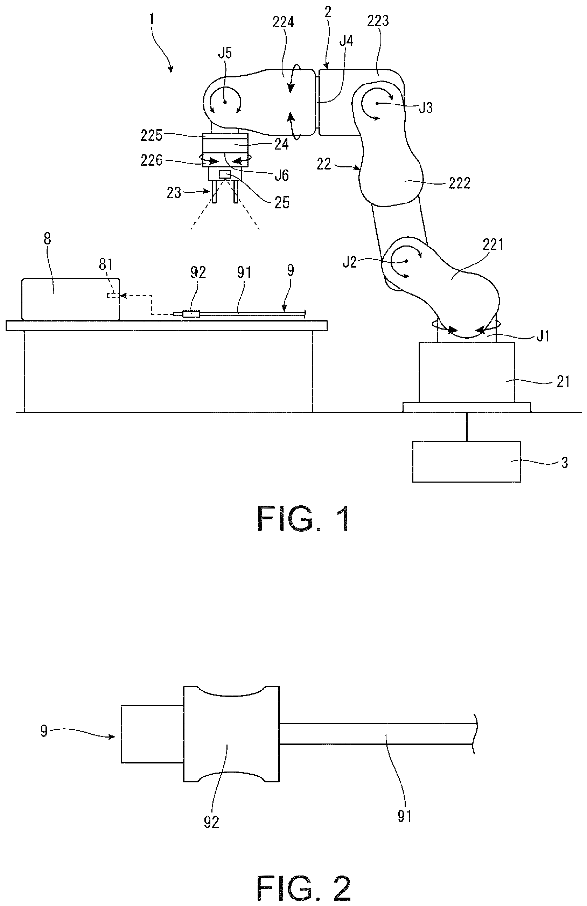

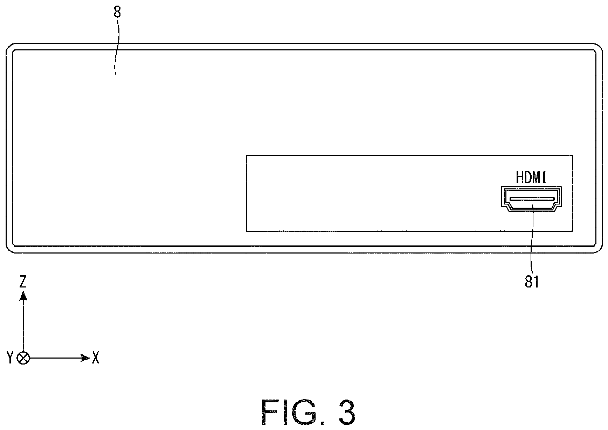

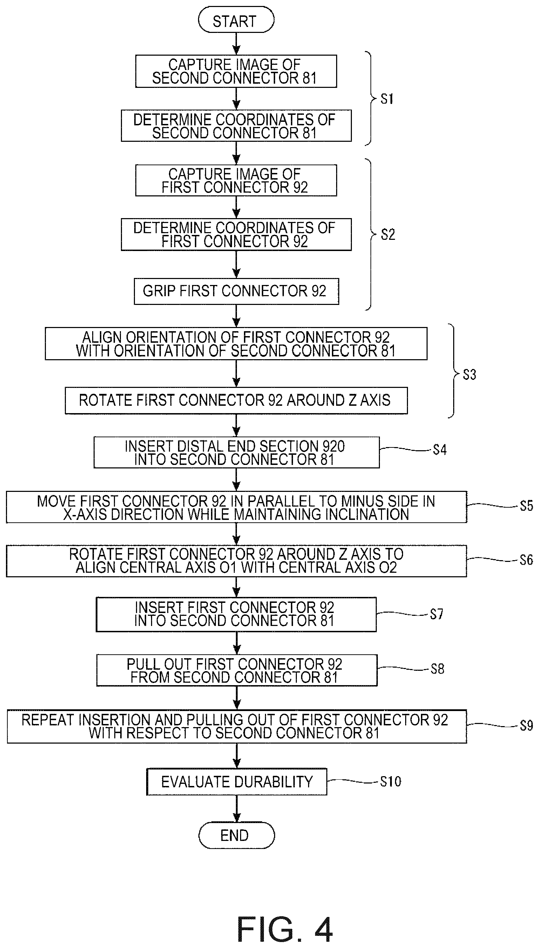

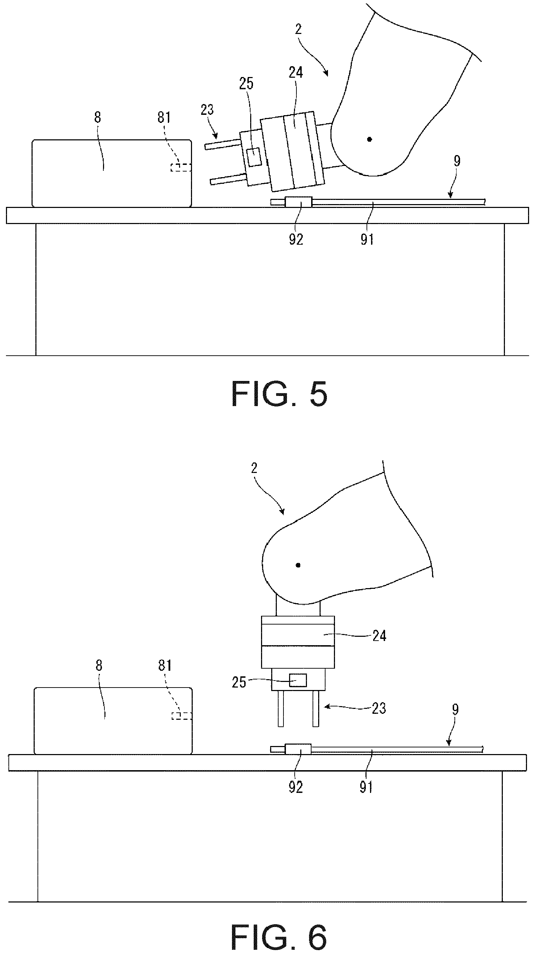

FIG. 1 is a configuration diagram of a robot system according to a first embodiment. FIG. 2 is a plan view showing a cable used in inspection. FIG. 3 is a rear view of an electronic device, which is the target of inspection. FIG. 4 is a flow chart of an inspection method performed using the robot system. FIGS. 5 to 14 are views for explaining the inspection method.

The robot system 1 shown in FIG. 1 has a robot 2 for inserting a grasped cable 9 into, and pulling out the grasped cable 9 from, an electronic device 8, and a control device 3 for controlling the driving of the robot 2.

The robot 2 is a six-axis vertically articulated robot having six drive shafts. Such a robot 2 has a base 21, a robot arm 22 rotatably connected to the base 21, a tool 23 mounted to the tip of the robot arm 22, a force sensor 24 arranged between the robot arm 22 and the tool 23, and an imaging device 25 arranged on the tool 23.

The robot arm 22 has a configuration in which six arms 221, 222, 223, 224, 225, and 226 are rotatably connected, and is provided with six joints J1, J2, J3, J4, J5, and J6. Among these six joints J1 to J6, the joints J2, J3, and J5 are bending joints, and the joints J1, J4, and J6 are twisting joints. Motors and encoders (not shown) are provided at the each of the joints J1, J2, J3, J4, J5, and J6. During the operation of the robot system 1, the control device 3 executes feedback control for each of the joints J1 to J6 so that the rotation angles of the joints J1 to J6 indicated by the outputs of the encoders match target positions.

The tool 23 has a pair of claws that open and close and the tool 23 clamps and grips the cable 9 using the pair of claws. However, the configuration of the tool 23 is not particularly limited as long as the cable 9 can be grasped. For example, the tool 23 may be configured to grip the cable 9 by suction.

The force sensor 24 has three detection axes orthogonal to each other, and can independently detect a translational force (axial force) along each detection axis and a rotational force (torque) about each detection axis. Such a force sensor 24 detects force applied to the cable 9 gripped by the tool 23. However, the configuration of the force sensor 24 is not particularly limited as long as the force applied to the cable 9 gripped by the tool 23 can be detected.

The imaging device 25 is, for example, a 3D camera (stereo camera). The control device 3 can specify the position (three dimensional coordinates) of the target, which is in the image, by performing image processing on the image data captured by the imaging device 25. However, the configuration of the imaging device 25 is not particularly limited as long as the same function can be achieved.

The control device 3 controls the driving of the robot 2. The control device 3 is composed of, for example, a computer, and has a processor (CPU) for processing information, a memory communicably connected to the processor, and an external interface for connecting to an external device. Various programs executable by the processor are stored in the memory and the processor can read and execute the programs stored in the memory.

Although the robot system 1 has been briefly described above, the configuration thereof is not particularly limited. For example, the robot 2 may not be a six-axis vertically articulated robot, but may be a horizontal articulated robot (SCARA robot).

Next, an inspection method using the above-described robot system 1 will be described. The connector insertion method using the robot system 1 will also be collectively described in the inspection method. In this inspection method, the insertion and pulling out of the cable 9 is repeated with respect to the electronic device 8, and the durability of the first connector 92 and the second connector 81 is evaluated. By this, the strength of the first connector 92 and the second connector 81 and the strength of the portion supporting the second connector 81 can be easily and accurately evaluated. However, the inspection contents are not particularly limited, and for example, the durability of only one of the first connector 92 and the second connector 81 may be evaluated, or another evaluation may be performed.

As shown in FIG. 2, the cable 9 is an actual cable that can be used in practice and has a flexible cable body 91 and a first connector 92 disposed at one end of the cable body 91. In this way, by using an actual cable 9, the actual use state can be reproduced and the accuracy of the insertion and pulling out inspection can be enhanced. However, the cable 9 may be an actual sized model (a mock up). The cable body 91 may be omitted from the cable 9.

On the other hand, as shown in FIG. 3, the electronic device 8 has on the rear surface thereof a second connector 81 into which the first connector 92 is inserted. The electronic device 8 is fixed by a fixing member (not shown) so as not to be displaced when the cable 9 is inserted and pulled out. Examples of the electronic device 8 include, but are not limited to, a projector, a printer, a personal computer, a display, and a robot controller.

In this embodiment, the first connector 92 is a male connector, and the second connector 81 is a female connector. However, they are not limited to this, and the first connector 92 may be a female connector and the second connector 81 may be a male connector. The standard of the connector is not particularly limited, and may be any standard such as USB type A, USB type C, USB mini, USB micro, HDMI (registered trademark), VGA, and LAN. In this embodiment, it is an HDMI (High-Definition Multimedia Interface). HDMI is a standard by which video and audio can be collectively transmitted through a single cable, and is widely used mainly in AV (Audio/Visual) type electronic devices 8. Therefore, it is possible to perform the insertion and pulling out endurance inspection for a larger number of electronic devices 8.

The inspection method includes, as shown in FIG. 4, a detection step S1 of detecting the position of the second connector 81, a gripping step S2 of gripping the cable 9, the axis shifting step S3 of shifting the axis of the first connector 92, a first insertion step S4 of inserting the distal end section of the first connector 92 into the second connector 81, an abutment step S5 of abutting the distal end section of the first connector 92 against the second connector, an axis alignment step S6 of aligning the axis of the first connector 92 with the axis of the second connector 81, a second insertion step S7 of inserting the first connector 92 into the second connector 81, a pull-out step S8 of pulling out the first connector 92 from the second connector 81, a repeated insertion and pull-out step S9 of repeatedly inserting and pulling out the first connector 92 with respect to the second connector 81, and an inspection step S10 of inspecting the state of the second connector 81.

Note that since the first connector 92 and the second connector 81 are both HDMIs, in plan view they have a flat shape having a short axis and a long axis orthogonal to each other. Therefore, hereinafter, for convenience of description, an axis along the long axis of the second connector 81 is defined as an X-axis, a direction along the short axis is defined as a Z-axis, and an axis along a central axis O2 is defined as a Y-axis. The direction along the X axis is also referred to as an X-axis direction, the direction along the Y axis is referred to as a Y-axis direction, and the direction along the Z axis is referred to as a Z-axis direction. The arrow side of each axis is also referred to as the plus side, and the opposite side as the minus side.

### Detection step S1

In the detection step S1, first, as shown in FIG. 5, the control device 3 moves the robot 2 so that the second connector 81 is located within the field of view of the imaging device 25, and the imaging device 25 captures an image of the second connector 81. Then, the control device 3 performs an image recognition process on the image data acquired by the imaging device 25 and detects the position of the second connector 81. Note that the position of the second connector 81 is, for example, the position of the end, that is, the open end, of the second connector 81. Position of the second connector 81 includes the meaning of the position and the posture (orientation) of the second connector 81.

### Gripping step S2

In the gripping step S2, first, as shown in FIG. 6, the control device 3 moves the robot 2 so that the first connector 92 is located within the field of view of the imaging device 25, and the imaging device 25 captures an image of the first connector 92. Then, the control device 3 performs image recognition processing on the image data acquired by the imaging device 25 and detects the position of the first connector 92. Note that the position of the first connector 92 is, for example, the position of the distal end of the first connector 92. The position of the first connector 92 includes the meaning of the position and posture (orientation) of the first connector 92.

Next, the control device 3 moves the robot 2 based on the detected position and grips the predetermined position of the first connector 92 with the tool 23.

### Axis shifting step S3

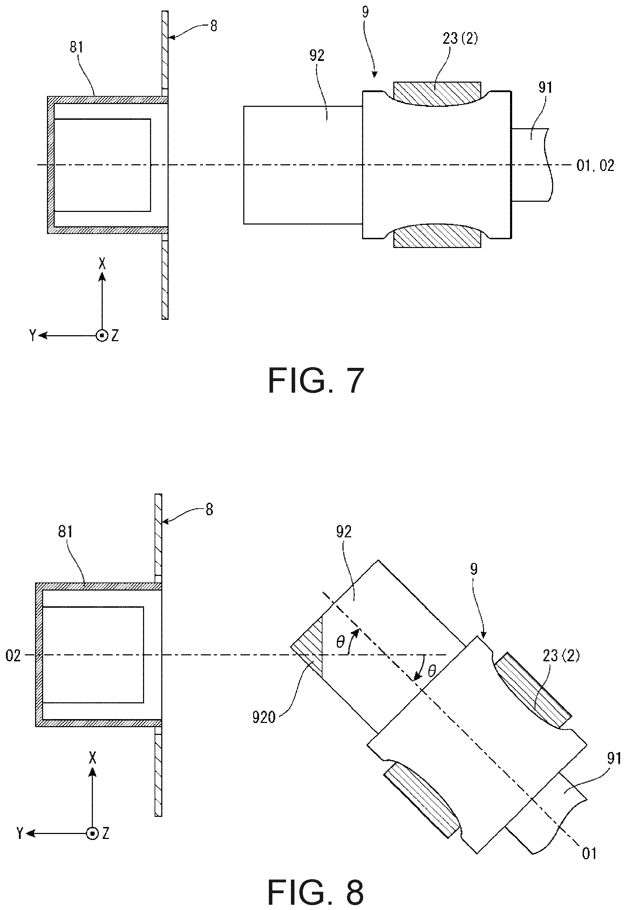

In the axis shifting step S3, first, as shown in FIG. 7, the control device 3 moves the robot 2 to align the orientation of the first connector 92 with the orientation of the second connector 81. That is, it aligns the central axis O1 of the first connector 92 with the Y axis, aligns the short axis with the Z axis, and aligns the long axis with the X axis. In the illustrated example, the first connector 92 directly faces the second connector 81 with the central axis O1 aligned with the central axis O2.

Next, as shown in FIG. 8, the control device 3 moves the robot 2 to rotate the first connector 92 about the Z axis by a predetermined angle and to tilt the central axis O1 of the first connector 92 with respect to the central axis O2 of the second connector 81. By this, of the distal end portion of the first connector 92, one long-axis-direction end section (the end section positioned on the minus side in the X-axis direction) protrudes toward the front side (towards plus side in the Y-axis direction) in the insertion direction of the first connector 92 with respect to the other end section (the end section positioned on the plus side in the X-axis direction). Note that hereinafter, for convenience of description, the one end section, that is, the portion indicated by hatching in the drawing, is also referred to as "distal end section 920".

Note that in this embodiment, the state shown in FIG. 8 is obtained via the state shown in FIG. 7, but the present invention is not limited to this, and the state shown in FIG. 8 may be obtained via another state or directly, without passing via another state. The axis of rotation is not particularly limited, and for example, the first connector 92 may be rotated around the X axis by a predetermined angle.

The axis shifting step S3 may be omitted and the central axis O1 may be tilted with respect to the central axis O2 of the second connector 81 when the first connector 92 is gripped in the gripping step S2.

### First insertion step S4

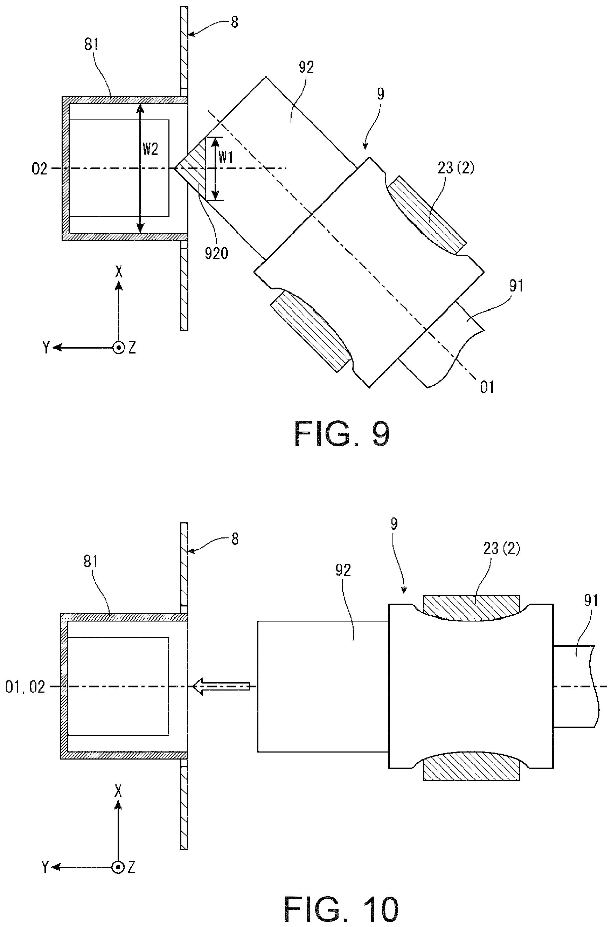

In the first insertion step S4, as shown in FIG. 9, the control device 3 moves the robot 2 to move the first connector 92 in parallel while maintaining the inclination of the first connector 92 with respect to the second connector 81, thereby inserting the distal end section 920 of the first connector 92 into the second connector 81. Here, by rotating the first connector 92 about the Z-axis in the axis shifting step S3, the width W1 (the length in the X-axis direction) of the distal end section 920 is smaller than the width W2 (the length in the X-axis direction) of the opening of the second connector 81. Further, the distal end section 920 is tapered toward the distal end side in the insertion direction. Therefore, for example, as shown in FIG. 10, the probability of a proper insertion can be increased as compared with a case where the first connector 92 is inserted into the second connector 81 with an orientation in which the central axis O1 of the first connector 92 is parallel to the central axis O2 of the second connector 81, and the insertion into the second connector 81 becomes easy.

Note that in some cases, the distal end section 920 of the first connector 92 collides with the second connector 81 due to a detection error of the positions of the first connector 92 or the second connector 81, a shift in the gripping position, or the like, so that further insertion is obstructed. Therefore, based on the force detected by the force sensor 24, the control device 3 detects the presence or absence of contact and the state of contact between the first connector 92 and the second connector 81 and, based on the detection result, proceeds with this step while finely adjusting the position of the first connector 92. By this, the distal end section 920 of the first connector 92 can be smoothly and more reliably inserted into the second connector 81. During this step, it becomes difficult to apply an excessive force to the first connector 92 and the second connector 81 and it is possible to effectively suppress that they break or deform.

Here, the inclination angle θ of the central axis O1 of the first connector 92 with respect to the central axis O2 of the second connector 81 is not particularly limited, but is, for example, desirably 30° or more and 60° or less, more desirably 40° or more and 50° or less, and still more desirably about 45°. By this, the width W1 of the distal end section 920 can be made sufficiently smaller than the width W2 of the opening of the second connector 81, the insertion success probability can be further increased, and this step can be performed more smoothly and more reliably.

### Abutment step S5

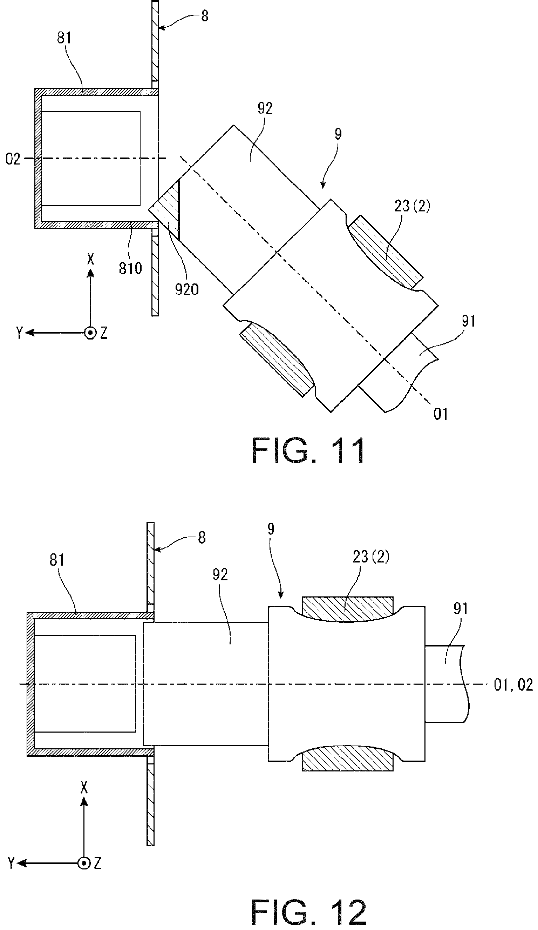

In the abutment step S5, as shown in FIG. 11, the control device 3 moves the robot 2 to move the first connector 92 in parallel to the minus side in the X-axis direction while maintaining the inclination of the first connector 92 with respect to the second connector 81, so that the distal end section 920 abuts against the inner wall 810 located on the minus side in the X-axis direction of the second connector 81. By this, the first connector 92 is positioned with respect to the second connector 81. Note that it should be noted that the determination as to whether abutment is made can be made based on the force detected by the force sensor 24.

### Axis alignment step S6

In the axis alignment step S6, as shown in FIG. 12, the control device 3 moves the robot 2 to rotate the first connector 92 about the Z-axis, so as to make it a state of the entire distal end surface of the first connector 92 being inserted into the second connector 81 and to align the central axis O1 of the first connector 92 with the central axis O2 of the second connector 81. In this case, it is desirable that the control device 3 rotates the first connector 92 around the contact point between the distal end section 920 and the inner wall 810 while maintaining the state in which the distal end section 920 abuts against the inner wall 810. By this, this step can be performed smoothly.

### Second insertion step S7

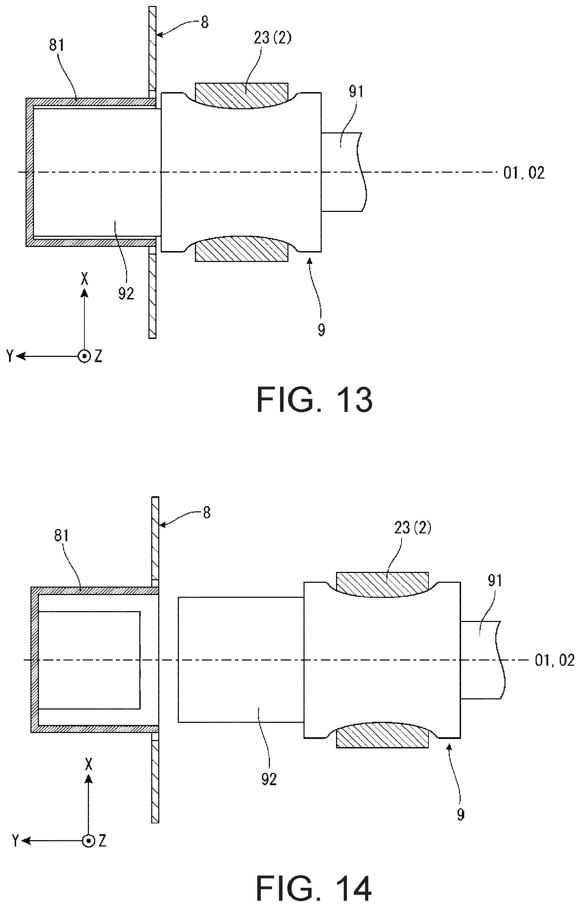

In the second insertion step S7, as shown in FIG. 13, the control device 3 moves the robot 2 to advance the first connector 92 along the central axis O1 toward the plus side in the Y-axis direction, to insert the first connector 92 into the second connector 81. By the above, the insertion of the first connector 92 is completed and the first connector 92 and the second connector 81 are connected to each other.

### Pull-out step S8

In the pull-out step S8, as shown in FIG. 14, the control device 3 moves the robot 2 to retract the first connector 92 along the central axis O1 to the minus side in the Y-axis direction to pull out the first connector 92 from the second connector 81.

### Repeated insertion and pull-out step S9

In the repeated insertion and pull-out step S9, the robot 2 is moved to advance the first connector 92 along the central axis O1 to the plus side in the Y-axis direction, to insert the first connector 92 into the second connector, resulting in the state shown in FIG. 13, and then to retract the first connector 92 along the central axis O1 to the minus side in the Y-axis direction to pull out the first connector 92 from the second connector 81, resulting in the state shown in FIG. 14, wherein these two states are regarded as one insertion and pulling out action, which is repeated for the number of times determined for the inspection. Note that this step can be performed smoothly by recording the position of the first connector 92 when the second insertion step S7 is completed and the position of the first connector 92 when the pull-out step S8 is completed and reciprocating the first connector 92 between the two positions.

### Inspection step S10

In the inspection step S10, the state of the second connector 81 itself and the state of the portion of the electronic device 8 holding the second connector 81 are confirmed to evaluate durability with respect to insertion and pulling out of the cable 9. The evaluation may be performed, for example, by the control device 3 by imaging the second connector 81 with the imaging device 25 and performing image processing on the image data, or by another inspection robot. It may be done visually by the operator.

The inspection method has been described above. According to this inspection method, the first connector 92 can be smoothly inserted into and pulled out from the second connector 81. Therefore, the time required for the inspection can be shortened.

The insertion method and inspection method for a connector using the robot system 1 has been described above. As described above, this connector insertion method is a connector insertion method in which the first connector 92 is inserted into the second connector 81 using the robot 2 and includes: the gripping step S2 in which the first connector 92 is gripped by the robot 2; the first insertion step S4 in which the distal end section 920 of the first connector 92 is inserted into the second connector 81 in the state in which the central axis O1 of the first connector 92 is shifted with respect to the central axis O2 of the second connector 81; the axis alignment step S6 in which the central axis O1 of the first connector 92 is aligned with the central axis O2 of the second connector 81 by displacing the first connector 92; and the second insertion step S7 in which the first connector 92 is advanced in the direction along the central axis O1 of the first connector 92 and inserted into the second connector 81. According to such a method, the probability of a successful insertion is increased and the first connector 92 can be inserted into the second connector 81 more reliably and smoothly.

As described above, in the first insertion step S3, the central axis O1 of the first connector 92 is inclined with respect to the central axis O2 of the second connector 81. By this, the width (length in the X-axis direction) of the distal end section 920 becomes smaller than the width (length in the X-axis direction) of the opening of the second connector 81. Therefore, it becomes easier to insert the first connector 92 into the second connector 81 in the first insertion step S4.

As described above, the connector insertion method includes the abutment step S5 that is performed between the first insertion step S4 and the axis alignment step S6 and in which the first connector 92 is moved in a direction orthogonal to the central axis O2 of the second connector 81, specifically, to the minus side of the X-axis direction, so that the distal end section 920 abuts against the second connector 81. By this, the first connector 92 can be positioned with respect to the second connector 81 prior to the axis alignment step S6.

As described above, in the axis alignment step S6, the first connector 92 is displaced while maintaining the state in which the distal end section 920 of the first connector 92 abuts against the second connector 81. By this, simultaneously with completion of this step, the central axis O1 of the first connector 92 substantially coincides with the central axis O2 of the second connector 81. In other words, it is possible to suppress deviation of the central axis O1 from the central axis O2 at the end of this step to a small amount.

As described above, the first connector 92 and the second connector 81 are HDMI connectors. HDMI is a standard enabling transmission of both video and audio, and is widely used mainly in AV (Audio/Visual) type electronic devices 8. Therefore, it is possible to perform the insertion and pulling out endurance inspection for a larger number of electronic devices 8.

As described above, the robot 2 has a force sensor 24 for detecting a force generated when the first connector 92 contacts the second connector 81. Then, in the first insertion step S4, the distal end section 920 of the first connector 92 is inserted into the second connector 81 based on the force detected by the force sensor 24. By this, the distal end section 920 of the first connector 92 can be smoothly inserted into the second connector 81. Excessive force is less likely to be applied to the first connector 92 and the second connector 81 and the breakage and deformation thereof can be effectively suppressed.

As described above, the inspection method is an inspection method for performing an inspection by inserting the first connector 92 into the second connector 81 using the robot 2 and includes the gripping step S2 for gripping the first connector 92 by the robot 2, the first insertion step S4 for inserting the distal end section 920 of the first connector 92 into the second connector 81 in the state where the central axis O1 of the first connector 92 is shifted with respect to the central axis O2 of the second connector 81, the axis alignment step S6 for aligning the central axis O1 of the first connector with the central axis O2 of the second connector 81, the second insertion step S7 for advancing the first connector 92 in the direction along the central axis O1 of the first connector 92 to insert the first connector 92 into the second connector 81, and the pull-out step S8 for retracting the first connector 92 in the direction along the central axis O1 of the first connector 92 to pull out the first connector 92 from the second connector 81. According to such an inspection method, the insertion and pulling out of the first connector 92 into and from the second connector 81 can be smoothly performed, and the time required for the inspection can be shortened.

As described above, the durability of the first connector 92 or the second connector 81 is inspected by the inspection method. In particular, in this embodiment, the durability of both is inspected. This makes it possible to easily and accurately evaluate the strength of the first and second connectors 92 and 81 themselves and the strength of the portion of the electronic device 8 that supports the second connector 81.

As described above, the inspection method is performed after the pull-out step S8 and includes the repeated insertion and pull-out step S9 in which the first connector 92 is repeatedly inserted into and pulled out from the second connector 81. By this, the durability of the first connector 92 and the second connector 81 can be effectively inspected.

### SECOND EMBODIMENT

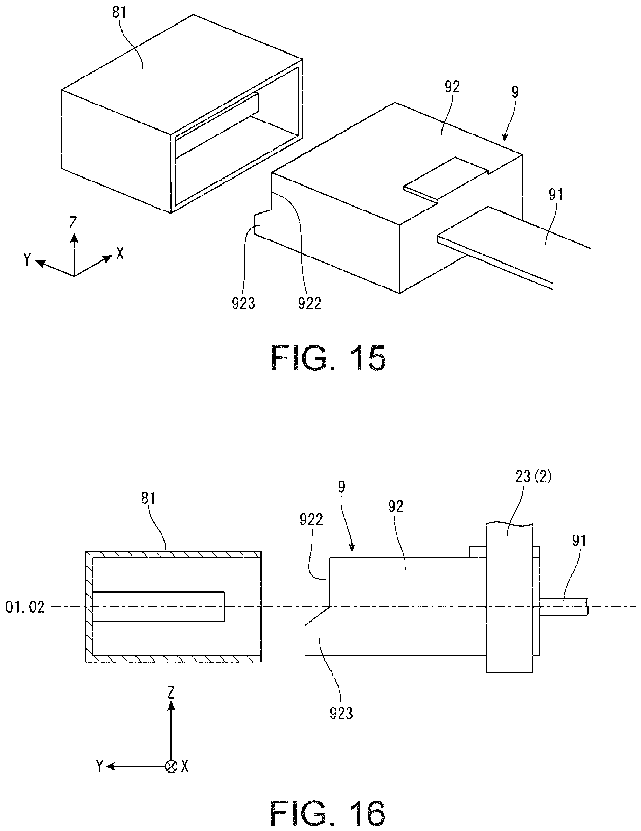

FIG. 15 is a perspective view showing a first connector and a second connector used in an inspection method of a second embodiment. FIGS. 16 to 20 are views for explaining the inspection method.

The robot system 1 according to the present embodiment is the same as the robot system 1 of the first embodiment described above, except that the shapes (standard) of the first and second connectors 92 and 81 are different. Note that in the following description, with respect to the robot system 1 of the present embodiment, the differences from the first embodiment will be mainly described, and the description of the points that are the same will be omitted. In the figures of this embodiment, the same components as those of the above-described embodiment are denoted by the same reference numerals.

As shown in FIG. 15, in this embodiment, the first connector 92 has a protruding section 923 that protrudes forward from the lower end section of the distal end surface 922. In such a case, the endurance inspection of the electronic device 8 is performed as follows.

In the inspection method of the present embodiment, the abutment step S5 of the above-described first embodiment is omitted, and includes the detection step S1, the gripping step S2, an axis shifting step S3, a first insertion step S4, an axis alignment step S6, a second insertion step S7, the pull-out step S8, the repeated insertion and pull-out step S9, and the inspection step S10. Among these steps, the detection step S1, the gripping step S2, the pull-out step S8, the repeated insertion and pull-out step S9, and the inspection step S10 are the same as those of the first embodiment described above, and therefore the description thereof will be omitted, and the axis shifting step S3, the first insertion step S4, the axis alignment step S6, and the second insertion step S7 will be described below.

### Axis shifting step S3

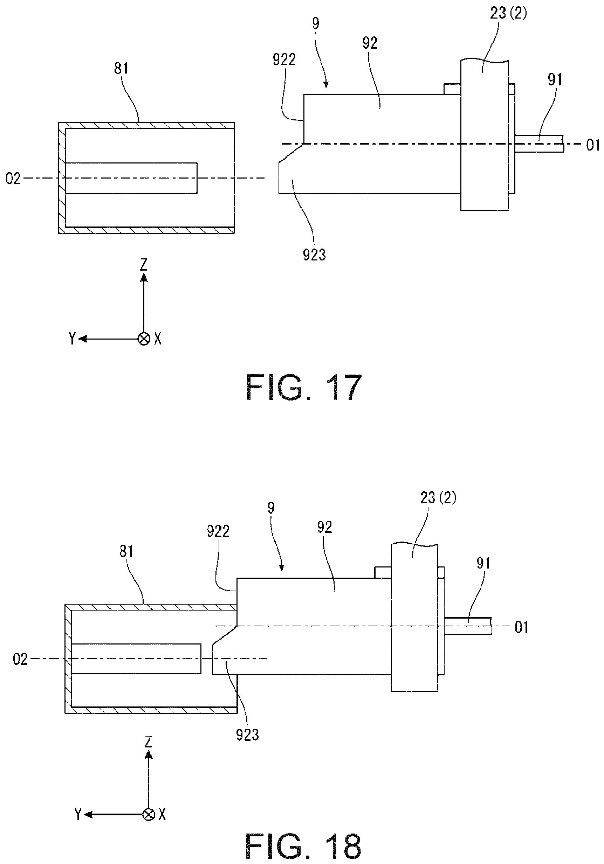

In the axis shifting step S3, first, as shown in FIG. 16, the control device 3 moves the robot 2 to align the orientation of the first connector 92 with the orientation of the second connector 81. Next, as shown in FIG. 17, the control device 3 moves the robot 2 to move the first connector 92 to the plus side in the Z-axis direction and shift the central axis O1 of the first connector 92 parallel in the Z-axis direction to the central axis O2 of the second connector 81.

### First insertion step S4

In the first insertion step S4, as shown in FIG. 18, the control device 3 moves the robot 2 to move the first connector 92 along the central axis O1 to the plus side in the Y-axis direction, thereby inserting the protruding section 923 into the second connector 81 and abutting the distal end surface 922 against the open end of the second connector 81. According to this method, the first connector 92 can be more easily inserted into the second connector 81 than, for example, in the case where the first connector 92 is inserted into the second connector 81 with the center axes O1 and O2 aligned.

### Axis alignment step S6

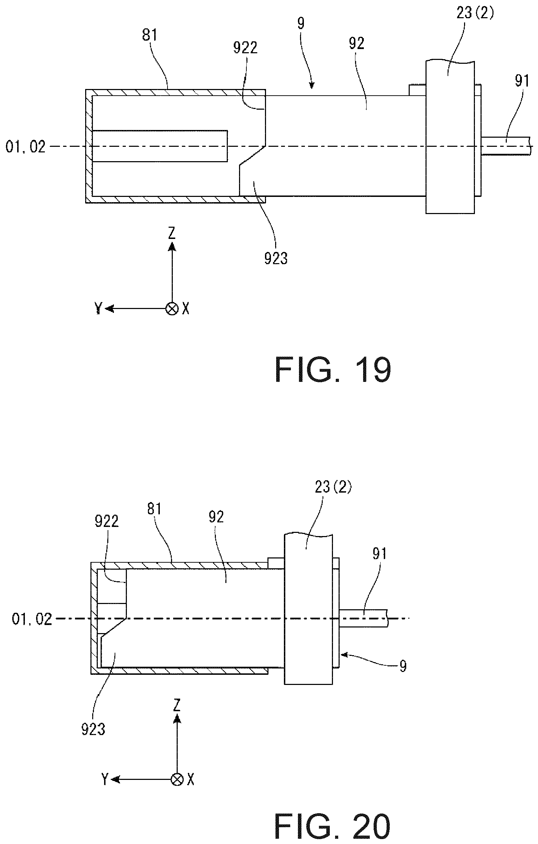

In the axis alignment step S6, as shown in FIG. 19, the control device 3 moves the robot 2 to move the first connector 92 to the minus side in the Z-axis direction so that the central axis O1 of the first connector 92 is aligned with the central axis O2 of the second connector 81.

### Second insertion step S7

In the second insertion step S7, as shown in FIG. 20, the control device 3 moves the robot 2 to advance the first connector 92 along the central axis O1 toward the plus side in the Y-axis direction, and inserts the first connector 92 into the second connector 81. By the above, the insertion of the first connector 92 is completed and the first connector 92 and the second connector 81 are connected to each other.

According to the second embodiment, the same effects as those of the first embodiment described above can be obtained.

### THIRD EMBODIMENT

The robot system 1 according to the present embodiment is the same as the robot system 1 of the first embodiment described above except that the inspection method is different. Note that in the following description, with respect to the robot system 1 of the present embodiment, the differences from the first embodiment will be mainly described, and the description of the points that are the same will be omitted.

The contents of the inspection performed by the inspection method of this embodiment are inspections of the insertion force for inserting the first connector 92 into the second connector 81 and the pull-out force for pulling out the first connector 92 from the second connector 81. By this, the ease of insertion and pulling out of the first connector 92 with respect to the second connector 81 can be evaluated.

The inspection method of this embodiment includes the detection step S1, the gripping step S2, the axis shifting step S3, the first insertion step S4, the abutment step S5, the axis alignment step S6, the second insertion step S7, the pull-out step S8, and an inspection step S10. That is, the repeated insertion and pull-out step S9 of the first embodiment is omitted. Note that the detection step S1, the gripping step S2, the axis shifting step S3, the first insertion step S4, the abutment step S5, the axis alignment step S6, the second insertion step S7, and the pull-out step S8 are the same as those in the first embodiment. Therefore, only the inspection step S10 will be described below.

### Inspection step S10

In inspection step S10, the control device 3 uses the force sensor 24 to detect the force applied to the first connector 92 in the second insertion step S7 and, based on the detected force, detects the insertion force necessary for inserting the first connector 92 into the second connector 81. Similarly, in the pull-out step S8, the control device 3 uses the force sensor 24 to detect the force applied to the first connector 92 and, based on the detected force, detects the pull-out force necessary for pulling out the first connector 92 from the second connector 81. By this, the ease of insertion and pulling out of the first connector 92 with respect to the second connector 81 can be evaluated.

As described above, in the inspection method of the present embodiment, the insertion force for inserting the first connector 92 into the second connector 81 or the pull-out force for pulling out the first connector 92 from the second connector 81 is inspected. By this, the ease of insertion and pulling out of the first connector 92 with respect to the second connector 81 can be evaluated.

According to the third embodiment as described above, the same effects as those of the first embodiment can be obtained.

### FOURTH EMBODIMENT

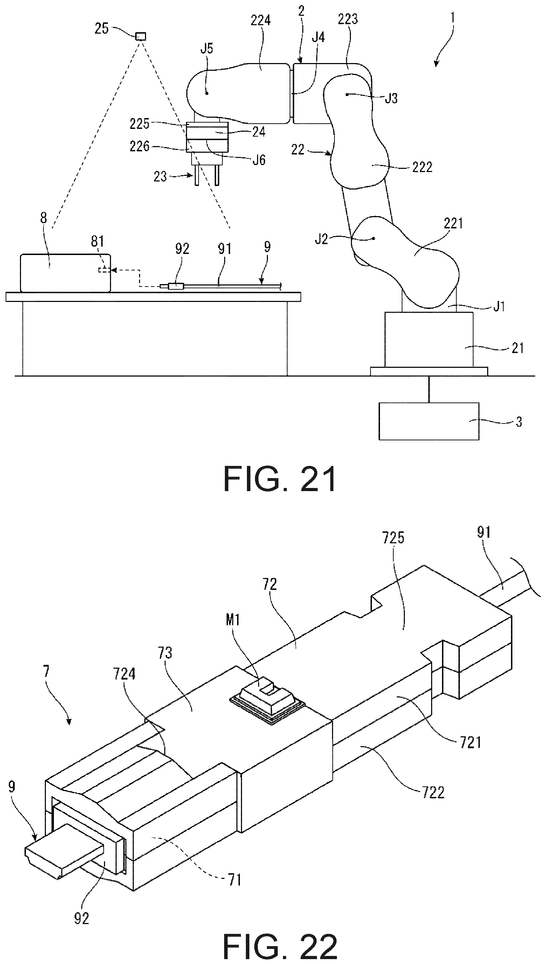

FIG. 21 is a configuration diagram of a robot system according to a fourth embodiment.

The robot system 1 according to this embodiment is the same as the robot system 1 of the first embodiment described above except for the arrangement of the imaging device 25. Note that in the following description, with respect to the robot system 1 of the present embodiment, the differences from the first embodiment will be mainly described, and the description of the points that are the same will be omitted. In the drawings of this embodiment, the same reference numerals are given to the same components as those of the above-described embodiments.

As shown in FIG. 21, in the robot system 1 of the present embodiment, the imaging device 25 is disposed, for example, immediately above the work space and fixed at a predetermined position, and is not disposed on the robot 2.

According to the fourth embodiment, the same effects as those of the first embodiment can be obtained. Note that in this embodiment, depending on the posture of the electronic device 8, it might not be possible to capture an image of the second connector 81 using the imaging device 25. In this case, for example, the position of the second connector 81 may be obtained in advance by another method and the obtained position may be stored in the control device 3.

### FIFTH EMBODIMENT

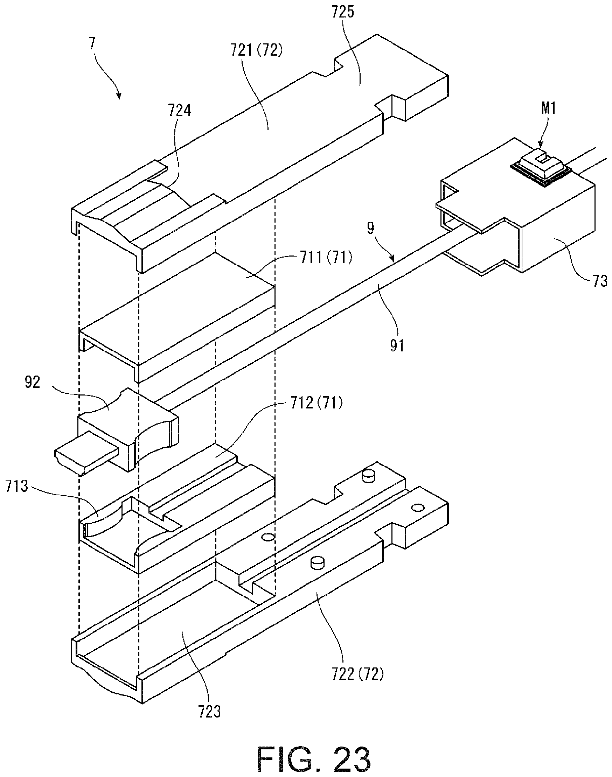

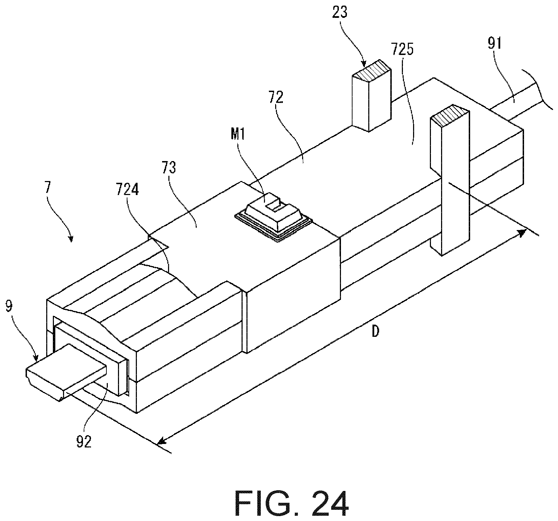

FIG. 22 is a perspective view showing a gripping jig used in an inspection performed by a robot system according to a fifth embodiment. FIG. 23 is an exploded perspective view of the gripping jig shown in FIG. 22. FIG. 24 is a perspective view showing a state in which the gripping jig is held by a tool.

The robot system 1 according to the present embodiment is the same as the robot system 1 of the first embodiment described above, except that a gripping jig 7 is mounted on the first connector 92 during inspection. Note that in the following description, with respect to the robot system 1 of the present embodiment, the differences from the first embodiment will be mainly described, and the description of the points that are the same will be omitted. In the figures of this embodiment, the same components as those of the above-described embodiment are denoted by the same reference numerals.

In the inspection of this embodiment, the gripping jig 7 is mounted on the first connector 92 prior to the gripping step S2. As shown in FIGS. 22 and 23, the gripping jig 7 has a base section 72 for gripping the first connector 92, a spacer 71 interposed between the base section 72 and the first connector 92, and a hollow lock section 73 into which the base section 72 is inserted. The spacer 71 is divided into spacer pieces 711 and 712 and the base section 72 is divided into base pieces 721 and 722. These sections are made of, for example, a resin material.

In the gripping jig 7, first, the body of the first connector 92 is sandwiched between the spacer pieces 711 and 712 to assemble the spacer 71. The spacer 71 has a positioning section 713 for positioning the first connector 92. By this, the first connector 92 can be disposed at a predetermined position with respect to the spacer 71 and displacement after positioning can be suppressed. The configuration of the positioning section 713 can be appropriately designed according to the body shape of the first connector 92 and, in the present embodiment, it is configured to have convex sections that engage with indentations of the body.

Next, the spacer 71 is sandwiched between the base pieces 721 and 722 and the base section 72 is assembled. The base section 72 has a positioning section 723 for positioning the spacer 71. By this, the spacer 71 can be disposed at a predetermined position with respect to the base section 72 and displacement after positioning can be suppressed. The configuration of the positioning section 723 can be appropriately designed according to the shape of the spacer 71. The positioning section 723 of the present embodiment is formed at the distal end section of the base section 72 and has a recess into which the spacer 71 is fitted.

Next, by inserting the lock section 73 into the base section 72, the assembled state of the spacer 71 and the base section 72 is maintained. The base section 72 has a positioning section 724 for positioning the lock section 73. By this, the lock section 73 can be disposed at a predetermined position with respect to the base section 72. The configuration of the positioning section 724 can be appropriately designed according to the shape of the lock section 73 and, in the present embodiment, the positioning section 724 is configured to have a wall section for abutting the lock section 73. By the above, assembly of the gripping jig 7 is completed. According to such a configuration, the gripping jig 7 can be easily mounted on the cable 9. Note that in the state where the gripping jig 7 is mounted, the distal end section of the first connector 92, more specifically, the entire male terminal portion (the portion to be inserted into the second connector 81) protrudes from the distal end of the gripping jig 7.

The gripping jig 7 has a recognition mark M1 for image recognition arranged on the upper surface of the lock section 73. The recognition mark M1 may be integrally formed with the lock section 73 or may be separately formed and bonded by an adhesive or the like.

The recognition mark M1 has a configuration that facilitates image recognition. Specifically, the recognition mark M1 has a color and gloss that facilitate image recognition. The recognition mark M1 is made of, for example, a resin material and the gloss thereof is sufficiently suppressed. It is colored differently from its surroundings. Therefore, the recognition mark M1 and the outline thereof appear clearly in image data. Therefore, it is possible to detect the position of the first connector 92 with higher accuracy than by detecting the position of the first connector 92 based on image data obtained by directly imaging the first connector 92. The recognition mark M1 has an appropriate size that is neither too small nor too large so that image recognition does not take too much time.

The recognition mark M1 has a three dimensional shape. Further, the side surface of the recognition mark M1 is inclined in a tapered shape and appears in image data obtained by imaging by the imaging device 25. Therefore, the amount of information relating to the recognition mark M1 increases, so that the image recognition of the recognition mark M1 can be performed with higher accuracy. Therefore, the position of the first connector 92 can be detected more accurately. However, the shape of the recognition mark M1 is not particularly limited and the side surface of the recognition mark M1 does not have to be tapered, and may have a planar shape formed by, for example, a printed layer, adhesion of a seal, or the like.

The base section 72 has a gripping section 725 to be gripped by the tool 23 of the robot 2. The gripping section 725 has a constricted shape with a pair of cut-out sections formed on both side surfaces of the base section 72. Then, as shown in FIG. 24, the gripping jig 7 can be held in a stable posture in the gripping step S2, by inserting the claw section of the tool 23 into the cutout sections to grip the gripping section 725.

The gripping section 725 is located on the proximal end side of the recognition mark M1, that is, behind the recognition mark M1 in the insertion direction. By this, a separation distance D between the tool 23 and the first connector 92 while the gripping section 725 is gripped by the tool 23 is increased and, for example, the first connector 92 can be inserted into the second connector 81 that is located at a place so deep that the first connector 92 could not be inserted if the first connector 92 were directly gripped by the tool 23. Therefore, the workability of the inspection is improved. However, the arrangement of the gripping section 725 is not particularly limited.

The gripping jig 7 has been described above. The relative positional relationship between the recognition mark M1 and the gripping section 725 (the amount of offset from the recognition mark M1) and the relative positional relationship between the recognition mark M1 and the first connector 92 (the amount of offset from the recognition mark M1) in a state where the gripping jig 7 is mounted on the first connector 92 are known in advance, and these relationships are stored in the control device 3. Therefore, when the control device 3 detects the position of the recognition mark M1 from the image acquired by the imaging device 25, the control device 3 can detect the positions of the gripping section 725 and the first connector 92 from the position of the recognition mark M1.

According to the fifth embodiment, the same effects as those of the first embodiment can be obtained.

The connector insertion method and inspection method of the present disclosure have been described above based on the illustrated embodiments, but the present disclosure is not limited thereto. The configuration of each part can be replaced with an arbitrary configuration having the same function. Other optional components or steps may be added to the present disclosure.

## Claims

1. A connector insertion method for inserting a first connector into a second connector using a robot, the connector insertion method comprising:
a gripping step of gripping the first connector by the robot;
a first insertion step of inserting a distal end section of the first connector into the second connector in a state where a central axis of the first connector is shifted from a central axis of the second connector;
an axis alignment step of displacing the first connector to align the central axis of the first connector with the central axis of the second connector; and
a second insertion step of advancing the first connector in a direction along the central axis of the first connector to insert the first connector into the second connector.

2. The connector insertion method according to claim 1, wherein
in the first insertion step, the central axis of the first connector is inclined with respect to the central axis of the second connector.

3. The connector insertion method according to claim 2, further comprising:
an abutment step performed between the first insertion step and the axis alignment step, and including moving the first connector in a direction orthogonal to the central axis of the second connector to abut the distal end section against the second connector.

4. The connector insertion method according to claim 3, wherein
in the axis alignment step, the first connector is displaced while maintaining a state in which the distal end section of the first connector is in abutment with the second connector.

5. The connector insertion method according to claim 1, wherein
the first connector and the second connector are HDMIs.

6. The connector insertion method according to claim 1, wherein
the robot has a force sensor for detecting a force generated when the first connector comes into contact with the second connector and
in the first insertion step, the distal end section of the first connector is inserted into the second connector based on the force detected by the force sensor.

7. An inspection method of inspecting by inserting a first connector into a second connector using a robot, the inspection method comprising:
a gripping step of gripping the first connector by the robot;
a first insertion step of inserting a distal end section of the first connector into the second connector in a state where a central axis of the first connector is shifted from a central axis of the second connector;
an axis alignment step of aligning the central axis of the first connector with the central axis of the second connector;
a second insertion step of advancing the first connector in a direction along the central axis of the first connector to insert the first connector into the second connector; and
a pull-out step of pulling out the first connector from the second connector by retracting the first connector in a direction along the central axis of the first connector.

8. The inspection method of claim 7, wherein
durability of the first connector or the second connector is inspected.

9. The inspection method of claim 7, wherein
an insertion force for inserting the first connector into the second connector or a pull-out force for pulling out the first connector from the second connector is inspected.

10. The inspection method of claim 8, further comprising:
after the pull-out step, a repeated insertion and pull-out step of repeatedly inserting and pulling out the first connector with respect to the second connector.
